# EUROPEAN PATENT SPECIFICATION

(11) **EP 2 813 360 B1**
(45) Date of publication and mention of the grant of the patent: **15.06.2016**
(21) Application number: 13746980.5
(22) Date of filing: 05.02.2013
(51) Int. Cl.: B32B 5/18, B32B 9/00, B65D 1/00, B65D 1/02, B65D 23/02, B65D 65/42, C23C 16/27, C23C 16/42, C23C 16/50

(54) **VAPOUR DEPOSITION FOAM**
DAMPFPHASENABSCHEIDUNGSSCHAUM
MOUSSE DE DÉPÔT EN PHASE VAPEUR

(30) Priority: 07.02.2012 JP 2012024383
(43) Date of publication of application: 17.12.2014
(73) Proprietor: Toyo Seikan Group Holdings, Ltd., Shinagawa-ku Tokyo 141-8627 (JP)
(72) Inventor: KOISO, Nobuhisa, Yokohama-shi, Kanagawa 240-0062 (JP); ICHIKAWA, Kentarou, Yokohama-shi, Kanagawa 240-0062 (JP); AIHARA, Takeshi, Yokohama-shi, Kanagawa 240-0062 (JP)
(74) Representative: Raynor, Stuart Andrew
(86) International application number: PCT/JP2013/052602
(87) International publication number: WO 2013/118718

(56) References cited:
- WO-A1-2009/119549
- JP-A- 2005 089 859
- JP-A- 2006 233 234
- JP-A- 2006 321 887
- JP-A- 2007 022 554
- JP-A- 2007 320 082
- JP-A- 2008 100 398
- JP-A- 2009 019 245
- JP-A- 2009 248 386
- JP-A- 2009 248 413
- JP-A- 2009 262 366

## Description

### Technical Field:

This invention relates to a vapor-deposited foamed body obtained by vapor-depositing a film on the surface of a foamed plastic formed body such as a foamed bottle.

### Background Art:

Containers made from a polyester as represented by polyethylene terephthalate (PET) excel in such properties as transparency, heat resistance and gas-barrier property, and have been widely used for a variety of applications.

Some contents contained in the packing containers may be subject to be degenerated with light. For example, some kinds of beverages, medicines, cosmetics and the like are, therefore, provided being contained in opaque containers formed by using a resin composition obtained by blending a resin with a coloring agent such as pigment. In recent years, however, there have been proposed a lot of containers imparted with light-blocking property based on foaming. For example, the present applicant has proposed several kinds of foamed bottles having walls foamed by microcellular technology (e.g., see patent documents 1 to 3).

The foamed plastic formed bodies such as the above foamed bottles are excellent in regard to their small weight and heat-insulating property in addition to light-blocking property accompanied, however, by a problem of a decrease in the gas-barrier property caused by foaming. In the field of packing such as containers, in particular, a decrease in the gas-barrier property is a serious problem since it permits the contents in the containers to be oxidized and deteriorated due to the permeation of oxygen. A decrease in the gas-barrier property caused by foaming can, of course, be alleviated if the foaming is suppressed as much as possible.

The present applicant, further, has proposed many means for improving the gas-barrier property by vapor-depositing a film on the inner surfaces of the containers by the plasma CVD method (e.g., see a patent document 4) . So far, however, nobody has ever attempted to a form vapor-deposited film on the foamed body. This was because in case a film was vapor-deposited on the foamed body, the film tended to be formed unevenly or tended to be peeled off making it difficult to obtain the gas-barrier property of the vapor-deposited film to a sufficient degree.

### Prior Art Documents:

### Patent Documents:

Patent document 1: JP-A-2007-022554
Patent document 2: JP-A-2007-320082
Patent document 3: JP-A-2009-262366
Patent document 4: JP-A-2006-233234

### Outline of the Invention:

### Problems that the Invention is to Solve:

It is, therefore, an object of the present invention to provide a vapor-deposited foamed body obtained by vapor-depositing a film on the surface of a foamed plastic formed body such as a foamed container, the vapor-deposited film being uniformly formed and being effectively prevented from peeling off.

Another object of the present invention is to provide a vapor-deposited foamed body and, specifically, a vapor-deposited foamed container featuring effectively improved gas-barrier property due to the vapor-deposited film and effectively suppressing a decrease in the gas-barrier property caused by foaming.

According to the present invention, there is provided a vapor-deposited foamed body having a film vapor-deposited on the surface of a foamed plastic formed body containing foamed cells therein, wherein in the surface of the foamed plastic formed body serving as the under-layer on where the film is to be vapor-deposited, the porosity of the foamed cells is suppressed to be not more than 30% in the surface layer portion to a depth of 50 *µ*m from said surface.

In the vapor-deposited foamed body of the present invention, it is desired that:
(1) The vapor-deposited film is a metal oxide film or a hydrocarbon film formed by the plasma CVD method;
(2) The foamed plastic formed body has been stretch-formed;
(3) The foamed plastic formed body is a container;
(4) The foamed plastic formed body is a container, and the film has been vapor-deposited on the inner surface thereof that comes in contact with the content; and
(5) The vapor-deposited film has a thickness in a range of 10 to 50 nm.

### Effects of the Invention:

The vapor-deposited foamed body of the present invention has a film that is vapor-deposited on the surface of a foamed plastic formed body in which foamed cells are distributed. Despite foamed cells are distributed in the interior of the formed body, the vapor-deposited film remains closely adhered to the surface thereof and exhibits its properties maintaining stability without being peeled off.

Specifically, when the vapor-deposited foamed body is used as a container, the vapor-deposited film exhibits its effects to its maximum degree. Upon forming the vapor-deposited film as described above, advantages of small weight and light-blocking property based on foaming are not impaired, a decrease in the gas-barrier property is effectively alleviated despite of foaming, and the quality of the contents in the container is effectively prevented from being deteriorated by oxidation.

### Brief Description of the Drawings:

[Fig. 1] is a sectional view of a foamed region of a vapor-deposited foamed body obtained by vapor-depositing a film on the surface of a foamed plastic formed body according to the present invention.
[Fig. 2] is a sectional view of a foamed region of a vapor-deposited foamed body (Comparative Example) obtained by vapor-depositing a film on the surface of an ordinary foamed plastic formed body.
[Fig. 3] is a diagram illustrating a process for producing the foamed plastic formed body shown in Fig. 1.
[Fig. 4] is a view showing a preform used for the production of a bottle which is a representative example of the vapor-deposited foamed body.
[Fig. 5] is a view of a foamed bottle obtained from the preform of Fig. 4.

Modes for Carrying Out the Invention:

### <Vapor-deposited foamed body>

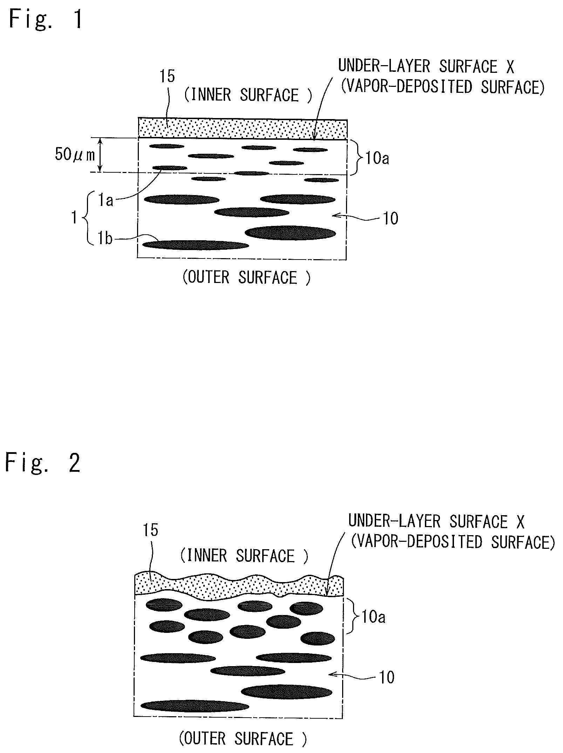

Referring to Fig. 1, the vapor-deposited foamed body of the present invention comprises a foamed plastic formed body as generally designated at 10 containing foamed cells 1 distributed therein, and a film 15 vapor-deposited on the surface thereof.

In Fig. 1, the foamed cells 1 have a flat shape but, not being limited to this shape only, may assume a spherical shape or a shape close to the spherical shape. If the formed body 10 is a container such as a plastic bottle, however, it has usually been stretched and the foamed cells 1 assume a flat shape being stretched in a direction of stretch.

The foamed cells 1 may be distributed throughout the whole formed body 10, or there may be employed such a foamed structure that some of the regions are not foamed and no foamed cell 1 is distributed therein. In a container that will be described later, for example, the mouth portion is not usually foamed but the body portion and the bottom portion are formed and foamed cells 1 are distributed therein for preventing the surface roughness lead to a decrease in the strength or a decrease in the sealing property due to the foaming.

The film 15 may be vapor-deposited on the whole surfaces of the formed body 10 but is, usually, vapor-deposited on either the outer surface or the inner surface to meet the object (in Fig. 1, the film 15 is vapor-deposited on the inner surface). For example, if the formed body 10 is a container, the film 15 that is vapor-deposited on the inner surface of the side in contact with the content, can be prevented from being damaged from the external side. Or the film 15 that is vapor-deposited on the outer surface can impart decorative appearance to the container.

In the invention, the vapor-deposited film 15 is necessarily present on the surface (either the inner surface or the outer surface) of a region of the formed body 10 in which the foamed cells 1 are present. In the portion on where the film 15 is vapor-deposited, however, it is important that the foaming has been suppressed in the surface layer portion 10a of the foamed body 10 that serves as the under-layer for the above portion. Concretely, the region up to a depth of 50 *µ* m from the surface X of the formed body 10 (surface of the under-layer) on which the film 15 is vapor-deposited is regarded to be the surface layer portion 10a, and it is essential that the porosity of the foamed cells 1 in this portion has been suppressed to be not more than 30% and, specifically, not more than 25%.

The porosity of the foamed cells 1 in the surface layer portion 10a, usually, stands for a volumetric ratio of the foamed cells 1 occupying the unit volume of the surface layer portion. For convenience, the porosity in the present invention is an area ratio in cross section of the surface layer portion.

That is, upon suppressing the foaming in the surface layer portion 10a on where the film 15 is vapor-deposited, it is allowed to effectively alleviate a decrease in the degree of smoothness of the under-layer surface X caused by foaming and, therefore, to turn the under-layer surface X into a surface of a high degree of smoothness (e.g., a mean surface roughness Ra of not more than 3.0 *µ*m) that is suited for vapor-depositing the film 15 thereon. This enables the vapor-deposited film 15 to be closely and firmly adhered to the under-layer surface X maintaining a uniform thickness. Even in case an external force is exerted thereon, therefore, the stress can be homogeneously dispersed over the whole area effectively preventing the vapor-deposited film 15 from being peeled off.

For example, reference should be made to Fig. 2 which shows the formed article 10 in which the porosity of the foamed cells 1 is exceeding 30% in the surface layer portion 10a thereof, and the film 15 is vapor-deposited on the under-layer surface X thereof.

In this case, the foaming has not been suppressed to a sufficient degree. Therefore, the under-layer surface X is greatly affected by an increase in the volume of the cells 1 due to foaming, and is greatly undulating. As a result, the vapor does not deposit evenly, the vapor-deposited film 15 does not firmly adhere to the under-layer surface X, fine gaps are formed between the under-layer surface X and the vapor-deposited film 15, and the thickness of the vapor-deposited film 15 becomes non-uniform. Moreover, in case an external force is exerted, the stress concentrates locally and, therefore, the film easily peels off. When the vapor-deposited foamed body is used as a container, in particular, these inconveniences appear as a decrease in the gas-barrier property.

In the present invention, the foaming in the surface layer portion 10a is suppressed as described above to prevent a decrease in the close adhesion between the vapor-deposited film 15 and the under-layer surface X caused by foaming, making it possible to vapor-deposit the film 15 maintaining uniform thickness and effectively preventing the vapor-deposited film 15 from being peeled off by the external force. Therefore, when the present invention is applied to the containers, in particular, a drop in the gas-barrier property is alleviated and a high gas-barrier property is attained.

In the present invention, further, the foaming has been suppressed in the surface layer portion 10a. As shown in Fig. 1, therefore, foamed cells 1a are small in size in the surface layer portion 10a (no foamed cell 1a is often present therein), and foamed cells 1b present in the region on the lower side (region on the side of the central portion) are larger than the foamed cells 1a. For example, if the formed body must have heat-insulating property and light-blocking property, then the properties can be attained by increasing the sizes of the foamed cells. However, if it is desired to attain both the adaptability to vapor deposition and the heat-insulating property or the light-blocking property, the large foamed cells in the surface layer are not desired. Therefore, the present invention is most desired forming the foamed cells in small sizes in the surface layer portion only. It is, as a matter of course, allowable, depending on the required properties, even if the foamed cells in the region on the side of the central portion are smaller than the foamed cells in the surface layer portion provided the forming conditions are optimized.

In the present invention, there is no particular limitation on the size of the foamed cells 1, on the cell density or on the ratio of the foamed cells 1 in the whole foamed body 10 so far as the foaming is so suppressed that the porosity in the surface layer portion 10a lies within the above-mentioned range, and they may be selected within suitable ranges depending on the use of the vapor-deposited foamed body.

For instance, the size of the foamed cells 1 and the cell density may be so set as to attain improved properties (e.g., light-blocking property, small weight and heat-insulating property) required for the foaming.

In the vapor-deposited foamed body having the structure mentioned above, there is no specific limitation on the plastic material used for forming the foamed plastic formed body 10 so far as it can be foamed or so far as it permits the vapor deposition as will be described later, and there can be used any known thermoplastic resins.

For instance, the foamed body 10 can be formed by using:
olefin resins such as low-density polyethylene, high-density polyethylene, polypropylene, poly 1-butene, poly 4-methyl-1-pentene or random or block copolymers such as ethylene, propylene, 1-butene, and 4-methyl-1-pentene, and cyclic olefin copolymers;
ethylene-vinyl copolymers such as ethylene-vinyl acetate copolymer, ethylene-vinyl alcohol copolymer, and ethylene-vinyl chloride copolymer;
styrene resins such as polystyrene, acrylonitrile-styrene copolymer, ABS, and *α* -methylstyrene-styrene copolymer;
vinyl resins such as polyvinyl chloride, polyvinylidene chloride, vinyl chloride-vinylidene chloride copolymer, methyl polyacrylate and methyl polymethacrylate;
polyamide resins such as nylon 6, nylon 6-6, nylon 6-10, nylon 11 and nylon 12;
polyester resins such as polyethylene terephthalate (PET), polybutylene terephthalate, polyethylene naphthalate and copolymerized polyesters thereof;
polycarbonate resin;
polyphenylene oxide resin; and
biodegradable resin such as polylactic acid.

It is allowable to form the foamed body 10 by using a blend of these thermoplastic resins, as a matter of course.

If the plastic foamed body 10 is a container, in particular, it is desired to use a polyester resin such as PET, or an olefin resin such as polyethylene and, most desirably, to use a polyester resin as a bottle for beverages.

Further, the film 15 is vapor-deposited by using various kinds of materials depending on the required properties. To impart optical properties as represented by antireflection property, for example, the film 15 is vapor-deposited by using a metal oxide such as SiO₂, TiO₂ or ZrO₂, or by using a fluoride such as MgF₂. When the gas-barrier property is required in the field of packing materials such as containers, further, the vapor-deposited film is formed by depositing a metal oxide such as SiO₂ or a hydrocarbon such as diamond-like carbon (DLC) or amorphous carbon. Further, the film 15 may be vapor-deposited in a multilayer structure overlapping the films formed by using the above-mentioned materials one upon another. In addition to the above, the vapor-deposited film 15 can be formed to work as an electrically insulating film, as a semiconductor film or as a decorative film for ornamentation, by using a material suited for the purpose.

Therefore, the thickness of the vapor-deposited film 15, too, is set depending upon the required properties to a degree that will not impair the properties of the foamed formed body 10. To improve gas-barrier properties required in the field of the containers such as plastic bottles, for example, the thickness of the vapor-deposited film 15 lies, preferably, in a range of 10 to 50 nm.

### <Production of the vapor-deposited foamed body>

The vapor-deposited foamed body of the above-mentioned structure is produced by preparing the foamed plastic formed body 10 by using the above-mentioned plastic material suppressing the foaming in the surface layer portion 10a, and vapor-depositing the film 15 on a predetermined portion of the formed body 10.

### 1. Preparation of the foamed plastic formed body 10:

The foamed plastic formed body 10 is produced by forming the above-mentioned plastic material or a composition comprising the above plastic material blended with suitable blending agents (e.g., antioxidant, etc.) followed by foaming during or after the step of forming.

As the above forming means, there can be exemplified known forming means such as extrusion forming, injection forming and compression forming. After the forming, it is allowable to further conduct a secondary forming such as stretch-forming. A desired shape is realized through the above forming.

The foaming can be conducted by chemical foaming using a foaming agent such as sodium bicarbonate or azo compound, or by physical foaming using an inert gas as the foaming agent. In the present invention, it is necessary to suppress the foaming in the surface layer portion 10a and, therefore, it is desired to employ the physical foaming that is capable of easily suppressing the foaming and, specifically, it is most desired to employ the microcellular foaming by which the inert gas imbibed as a foaming agent in the resin grows into bubbles to form foamed cells from such a standpoint that the foamed cells are small in size and that physical properties such as strength and the like are little affected by the foamed cells.

The foamed plastic formed body that is foamed relying on the above microcellular foaming can be obtained by using known methods (e.g., patent documents 1 to 3 and WO2009/119549) which the present applicant have proposed so far and by so adjusting the foaming conditions that the foaming in the surface layer portion 10a satisfies the above-mentioned porosity.

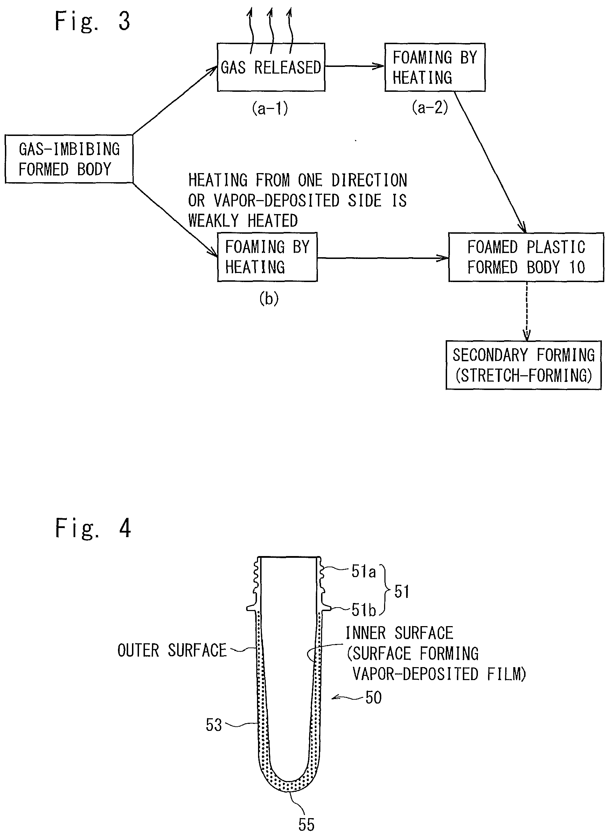

Fig. 3 illustrates a process for producing the foamed plastic formed body 10 by utilizing the microcellular foaming.

Namely, according to the above method as shown in Fig. 3, a gas-imbibed formed body is prepared in which the inert gas (nitrogen gas or carbon dioxide gas) that serves as the foaming agent is dissolved, and the gas-imbibed formed body is foamed by heating it to a degree (e.g. , melting point or softening point thereof) by which the formed body is not thermally deformed to thereby obtain a foamed plastic formed body 10 of a desired shape. After the foaming, further, the secondary forming is conducted, such as stretch-forming, to obtain the foamed plastic formed body 10 of the final shape. In the present invention, the foaming conditions are set in the step of forming so that the foaming in the surface layer portion 10a satisfies the above-mentioned porosity.

First, the gas-imbibed formed body imbibing the inert gas is obtained by forming an unfoamed formed body by the above-mentioned known forming means, and placing the unfoamed formed body in an inert gas atmosphere of a high pressure under a condition of being heated or not heated. The higher the temperature, the smaller the amount of gas dissolved therein but the larger the imbibition rate is. The lower the temperature, the larger the amount of gas dissolved therein but the longer the time needed for the imbibition.

It is, further, allowable to obtain the formed body imbibing the inert gas by feeding the inert gas under high pressure to the melt-kneading portion of the forming machine and directly feeding the plastic material for forming in which the inert gas is dissolved to the forming such as injection-forming. In this case, to obtain the formed body free of defective appearance such as swirl marks by preventing foaming in the injection-forming machine, it is desired to conduct the forming by injection-filling the plastic material for forming in which the inert gas is dissolved while maintaining the pressure in the mold cavity in which a high pressure is maintained as proposed in WO2009/119549 filed by the present applicant.

The foaming is conducted by heating the gas-imbibing formed body that is obtained as described above. Here, in the present invention, it is necessary to suppress the foaming in the surface layer portion 10a. The process for obtaining the foamed plastic formed body 10 by suppressing the foaming can be divided, as shown in Fig. 3, into a process that executes the foaming after having released the gas and a process that controls the heating during the foaming.

Referring to Fig. 3, the gas-releasing process releases the inert gas from the surface layer portion 10a of the gas-imbibing formed body (a-1) and, next, conducts the foaming by heating (a-2).

The gas is released from the surface layer portion 10a by, for example, placing the gas-imbibing formed body taken out in a cooled and solidified state from the mold under a normal pressure (atmospheric pressure) for a predetermined period of time so that the inert gas is released from the surfaces thereof and, next, heating the formed body so as to be foamed.

Upon releasing the gas as described above, the inert gas is no longer dissolved or the concentration of the inert gas is very decreasing in the surface layer portion 10a. By conducting the heating under this condition, therefore, it is allowed to suppress the foaming in the surface layer portion 10a. This is because the porosity decreases in the surface layer portion 10a where the gas concentration is low, as a matter of course. The amount of gas remaining in the surface layer portion 10a can be adjusted depending on the time in which the gas-imbibing formed body is placed under the atmospheric pressure for releasing gas (substantially, depending on the time until the foaming by heating is effected next time). Namely, the longer the time of placing the formed body under the open atmosphere, the closer to zero the amount of gas in the surface layer portion 10a is. The shorter the time of placing the formed body under the open atmosphere, the larger the amount of gas in the surface layer portion 10a is and the higher the porosity is. Here, attention should be given to that if the formed body is placed under the open atmosphere for unnecessarily longer periods of time, then the foaming does not take place or takes place to a very small degree making it difficult to achieve the object of foaming.

In the surface layer portion 10a, the foaming may be suppressed in only a portion on where the film 15 is vapor-deposited. Therefore, means may be employed so as to expose only the potion where the film 15 is vapor-deposited to the atmosphere to release the gas while covering other portions so will not be exposed to the atmosphere. This makes it possible to selectively release the gas from only the portion on where the film 15 is to be vapor-deposited. For example, if the film is vapor-deposited on the inner surface side of the formed body 10 as shown in Fig. 1, then the gas may be released from at least the inner surface side of the formed body 10.

After the inert gas serving as the foaming agent was released from the surface layer portion 10a as described above, the formed body is heated and foamed (a-2) to obtain the foamed plastic formed body 10 suppressing foaming in the surface layer portion 10a.

Due to the heating in the step (a-2), the inert gas inflates to generate and grow the cells; i.e., foaming is attained. The heating temperature is such that the formed body is not thermally deformed but is at least higher than the glass transition point (Tg) of the resin. The higher the heating temperature, the larger the size of the foamed cells and the higher the porosity is. However, there is no inert gas in the surface layer portion 10a to generate the foamed cells. Therefore, attention should be given to that the bubbles do not so grow in the region under the surface layer portion 10a as to infiltrate into the surface layer portion 10a to increase the porosity therein.

Suppressing the foaming based on the above method is particularly advantageous when it is attempted to suppress the foaming in both the inner surface and the outer surface since the gas has already been released from the surface layer portion 10a. This also gives such an advantage that the porosity in the surface layer portion 10a can be decreased to substantially zero.

The heating for foaming is not specifically limited, and can be carried out by any means such as blowing the hot air, using an infrared-ray heater or a high frequency heating, or an oil bath.

The heating for foaming needs not be effected for the regions where no foaming is necessary, as a matter of course. For example, the mouth portion of the container must avoid the foaming that causes a decrease in the strength or a decrease in the smoothness (decrease in the sealing property). Therefore, if the mouth portion, too, is imbibing the gas, the heating is selectively effected for only the portions that require foaming so that no foaming takes place in the mouth portion. When a multiplicity of layers are injected such that the mouth portion is formed from a non-foaming resin and at least part of the body portion is formed from a foaming resin and, thereafter, when the mouth portion is crystallized, then there is no need of avoiding the heating for the mouth portion.

In another process, the gas is not released from the surface layer portion 10a, and the gas-imbibing formed body is directly introduced into the foaming step (b) to heat and foam the gas-imbibing formed body.

The heating and foaming are conducted in basically the same manner as in the step (a-2) that is conducted after the gas is released with, however, a great difference in regard to that the surface of the surface layer portion 10a is not positively foamed by heating. For example, if the film 15 is to be vapor-deposited on the inner surface side of the formed body 10 as shown in Fig. 1, then the heating may be effected from outer surface side. Or if the heating is effected from the inner and outer surface sides, then the heating on the inner surface side may be weakened. That is, the foaming may be attained by so effecting the heating that the temperature in the surface layer portion 10a does not become higher than the glass transition point or the temperature therein is not maintained to be higher than the glass transition point for long periods of time. Due to the above heating and foaming, the temperature becomes sufficiently high (to a degree by which the formed body 10 is not deformed) in the portions other than the surface layer portion 10a, and the foamed cells grow into a large size. In the surface layer portion 10a, however, the foamed cells are limited from generating or growing.

When the foaming in the surface layer portion 10a is controlled by the above means, the foaming takes place due to the conduction of heat to the side of the surface layer portion 10a from the surface on the side opposite to the surface layer portion 10a (surface X under the vapor-deposited film 15) in which the foaming is controlled. Therefore, the foamed cells located on the side opposite to the surface layer portion 10a have the largest size, and the size of the foamed cells decreases toward the surface layer portion 10a (so-called inclined foaming). If it is attempted to decrease the weight by foaming by increasing the porosity in the foamed formed body 10, then the above means is particularly advantageous in such cases where the heating cannot be effected from the one side though there remains a probability that the porosity cannot be decreased down to 30% or smaller in the surface layer portion 10a.

The heating step (a-2) conducted after the gas has been released, too, may employ the above method of effecting the heating from the one side or the method of weakening the heating from the inner surface side.

As described above, foaming is suppressed in the surface layer portion 10a, and there is obtained the foamed plastic formed body 10 having the film 15 vapor-deposited on the surface layer portion 10a.

As shown in Fig. 3, further, the formed body 10 can be subjected to the secondary forming such as stretch-forming. In the case of such containers as bottles or cups, for example, the foamed plastic formed body 10 obtained through the above steps is a primarily formed body (preform) which is, thereafter, subjected to the stretch-forming so as to be shaped into a container which is the secondarily formed body. Therefore, the foamed cells 1 (1a, 1b) of flat shapes shown in Fig. 1 are those of the secondarily formed body that is stretch-formed. The foamed cells 1 that have not been subjected to the secondary forming such as stretch-forming assume a shape close to nearly a spherical shape.

When the secondary forming is conducted as described above, it is important that the foaming has been suppressed in the surface layer portion of the primarily formed body so that the porosity in the surface layer portion 10a after the secondary forming lies in the above-mentioned range. This is because the film 15 is vapor-deposited on the surface of the secondarily formed body and, besides, depending on the secondary forming such as stretching, the thickness decreases and the position that used to be 50 *µ*m deep from the surface may vary.

Fig. 4 shows a preform for forming a bottle which is the primarily formed body.

The preform generally designated at 50 has the shape of a test tube and is forming, at its upper portion, a neck portion 51 having a screw thread 51a and a support ring 51b. A body portion 53 and a bottom portion 55 are formed on the lower side of the neck portion 51.

In the case of a plastic bottle, in general, if a gas is dissolved in a portion such as the mouth portion on where the screw thread has been formed, an attempt of foaming the portion such as the mouth portion causes a decrease in the strength or a decrease in the sealing property due to roughened surfaces. Therefore, the neck portion 51 of the preform 50 is not subjected to the above-mentioned heating for forming, but the body portion 53 and the bottom portion 55 are foamed, i.e., are foamed by heating to form a foamed region where there are distributed foamed cells of a spherical shape or of a shape close to the spherical shape. If a multiplicity of layers is injected so that the mouth portion is formed from a non-foaming resin and at least part of the body portion is formed from a foaming resin and if, thereafter, the mouth portion is crystalized, then there is no need of avoiding the heating for the mouth portion.

In case the film is to be vapor-deposited on the plastic bottle in a manner that the vapor-deposited film can be prevented from being damaged by the external pressure or the like, then the film is vapor-deposited on the inner surface of the bottle. In this case, therefore, the heating is so effected that the foaming is suppressed in the surface layer portion on the inner surface side of the preform 50. Even if the film 15 has not been vapor-deposited, it is desired that the bottle that is finally obtained has smoothness on the outer surface, too. It is, therefore, desired that the surface layer portion on the outer surface side, too, is suppressed from being foamed by the above-mentioned method. Further, if the film 15 is vapor-deposited on the outer surface side so that the surface of the plastic bottle exhibits brilliant specular luster, then the heating is so effected that the foaming is suppressed in the surface layer portion on the outer surface side of the preform 50. In this case, too, the foaming may be suppressed both in the surface layer portion on the outer surface side and in the surface layer portion on the inner surface side, as a matter of course.

If the foaming is effected in order to impart light-blocking property to prevent the content from being degenerated, it is desired that the amount of gas that is imbibed, the heating temperature and the heating time for foaming are so adjusted that the density of the foamed cells becomes about 10⁵ to about 10¹⁰ cells/cm³ in the central portions, except the surface layer portion where the foaming is limited, in the foamed regions (body portion 53 and bottom portion 55) of the preform 50 which is the primarily formed body, that the mean diameter thereof (equivalent circle diameter) becomes about 3 to about 50 *µ*m and that the number of bubbles is not less than 17 in the direction of thickness of the bottle after it has been blow-formed.

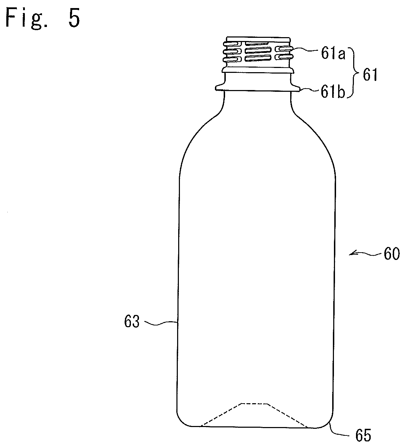

A foamed bottle 60 (secondarily formed body) of a shape shown, for example, in Fig. 5 is obtained by stretch-forming (blow-forming) the above preform 50. The foamed bottle 60 is forming a neck portion 61 having a screw thread 61a and a support ring 61b corresponding to the above preform 50, and is forming a body portion 63 and a bottom portion 65 on the lower side of the neck portion 61. The body portion 63 and the bottom portion 65 are the foamed regions in which the foamed cells are distributed.

The foamed bottle 60 has been stretch-formed and, therefore, the foamed cells 1 which were nearly of a spherical shape in the preform 50 are now assuming a flat shape being stretched in the direction of stretch as shown in Fig. 1.

In the above foamed bottle 60, the film 15 is vapor-deposited on the inner surface thereof. Therefore, the foaming has been so suppressed that the porosity lies in the above-mentioned range (not more than 30% and, specifically, not more than 25%) in the surface layer portion 10a that has the under-layer surface X (on where the vapor deposits).

There is no need of limiting the foaming in the outer surfaces of the foamed regions (body portion 63 and bottom portion 65) of the foamed bottle 60 unless the film 15 is not vapor-deposited thereon. On these regions, too, however, it is desired to form an unfoamed skin layer (layer without substantially containing any foamed cell) and, specifically, on the outer surface of the body portion 63 to improve smoothness and, therefore, to improve printability and easiness for sticking labels. The skin layer can be easily formed by releasing the gas prior to conducting the foaming.

There is no need of limiting the foaming in the inner part (region which is not the surface layer) of the foamed bottle 60, and the porosity may be set depending on the object. If it is desired to obtain a lowly light-blocking bottle, then the number of bubbles may be decreased in the direction of thickness of the bottle. Further, the central region may be left unfoamed by adjusting the forming conditions.

The foamed preform 50 is stretch-formed by blow-forming the preform while heating it at a temperature higher than a glass transition point of the resin but lower than a melting point thereof. Depending on the state of the container or the preform, however, the stretch-forming may be effected relying on the vacuum forming as represented by the plug-assist forming. For example, if it is attempted to produce a foamed container of the shape of a cup, the foamed preform (primarily formed body) of the shape of a plate or a sheet is formed according to the method described above, and is subjected to the secondary forming such as the plug-assist forming. Irrespective of which stretch-forming means is employed, the foaming in the surface layer portion may be so suppressed that the porosity is not larger than a predetermined value in the surface layer portion 10a in the portion that serves as the under-layer surface X (on where the vapor deposits) on where the film 15 is to be vapor-deposited.

The secondary forming such as blow forming or vacuum forming may be conducted relying on a means that has been known per se., as a matter of course.

For example, in the blow forming which executes the stretching in two directions of the axial direction (direction of height) and the circumferential direction, the axial direction is, usually, the direction of a maximum stretch. Therefore, the porosity in the surface layer portion 10a may be rendered to lie in a predetermined range by forming foamed cells 1 of a flat shape having a suitable length (maximum length in the direction of stretch) and an aspect ratio by adjusting the stretching ratio in the axial direction to lie in a suitable range.

In the foamed plastic formed body 10 obtained as described above, the film 15 is vapor-deposited on the vapor deposition surface (under-layer surface X which is the surface of the surface layer portion 10a) in which the foaming has been suppressed.

### 2. Vapor-depositing the film 15:

According to the invention, the film 15 is vapor-deposited by a known means, i.e., physical vapor deposition such as vacuum evaporation, sputtering or ion plating, or chemical vapor deposition such as plasma CVD depending on properties such as heat resistance of the foamed plastic formed body 10 and the form thereof, on the position on where the film 15 is to be deposited and on the use of the formed body 10.

The vapor-deposited foamed body of the invention is very advantageous from the standpoint of improving gas-barrier property by vapor-depositing the film 15 (from the standpoint of avoiding a decrease in the gas-barrier property caused by foaming). Most of the vapor-deposited foamed bodies assume the form of the bottle 60 described above. In such packing containers, it is desired that the film 15 is vapor-deposited by the plasma CVD that can be executed at a relatively low temperature from the standpoint of the container material (usually, polyester or polyolefin) and, most desirably, the film 15 is vapor-deposited by the microwave plasma CVD that forms the film by generating a plasma by feeding microwaves into the container. A high frequency plasma CVD, too, can be applied requiring, however, the body portion of the container on where the film is to be deposited to be positioned between the electrodes and, therefore, requiring a complex apparatus, which is not so much desired.

The plasma CVD is desired not only when it is attempted to vapor-deposit the film 15 on the inner surface of the packing container but also when it is attempted to vapor-deposit the film 15 on the outer surface of the packing container in order to impart decorative appearance to the surface of the packing container, i.e., to impart brilliant specular luster thereto, and the microwave plasma CVD is most desired.

Representative examples of the vapor-deposited film 15 for improving gas-barrier property include metal oxide films such as SiO₂, and hydrocarbon films such as diamond-like carbon (DLC) and amorphous carbon. The film 15 can be vapor-deposited on the inner surface of the container by the microwave CVD relying on a means that has been known per se., e.g., relying on a method disclosed in JP-A-2006-233234 filed by the present applicant.

If a metal oxide film such as SiO₂ is to be deposited, there can be used, as the reaction gas, an organometal compound, such as:
a silane compound like hexamethyldisilane, vinyltrimethylsilane, vinyltrimethoxysilane or tetramethoxysilane;
an organoaluminum compound like trialkyl aluminum; or
an organotitanium compound; depending on the kind of the metal with which the film is to be formed. The organometal compound gas is used being suitably mixed with an oxidizing gas such as oxygen or a carrier gas such as nitrogen.

If a hydrocarbon type film is to be deposited, there is preferably used, as the hydrocarbon source, a hydrocarbon compound such as unsaturated aliphatic hydrocarbon or aromatic hydrocarbon that can be easily gasified. Representative examples of the unsaturated aliphatic hydrocarbon include:
alkenes such as ethylene, propylene, butene and pentene; and
alkynes such as acetylene and methylacetylene.

Representative examples of the aromatic hydrocarbon include benzene, toluene and xylene. Usually, the unsaturated aliphatic hydrocarbons are desired and, specifically, ethylene and acetylene are most desired. The hydrocarbon source gas is used as a reaction gas being suitably mixed into a gas of a compound (e.g., oxygen-containing gas such as methanol, ethanol or acetone) that introduces polar groups into the film to improve close adhesion of the formed body 10 to the under-layer surface X.

The plasma CVD by using the above reaction gas is conducted in a manner of, for example, holding a container upside down in a plasma treatment chamber that has been shielded with a suitable metal wall, inserting a gas pipe in the mouth portion of the container to feed the reaction gas into the container, deaerating the interior of the container in this state to a vacuum degree that enables a plasma to be generated, deaerating the exterior of the container, too, to such a vacuum degree that does not cause the container to be deformed, feeding microwaves into the chamber (into the container) through a conduction pipe such as waveguide, generating a plasma by using the energy of microwaves and, at the same time, feeding the above-mentioned reaction gas through a gas pipe to cause the reaction so as to form the film.

In depositing the film as described above, it is allowable to change the composition of the vapor-deposited film 15 by, for example, adjusting the composition of the reaction gas or the output of microwaves. For example, if a film of a metal oxide such as SiO₂ is to be deposited, the amount of the organic component in the film can be increased by decreasing the output thereby to improve flexibility or softness of the film and to, further, improve close adhesion to the under-layer surface X. Therefore, the film is deposited starting, first, with a low output which is then gradually increased to form a film having a high degree of oxidation and a high gas-barrier property.

The film 15 is deposited on a predetermined surface of the foamed plastic formed body 10 (e.g., bottle 60 of Fig. 5) in a manner as described above. In this invention, foaming has been suppressed in the surface layer portion 10a that is forming the under-layer surface X on where the film 15 is vapor-deposited. Therefore, the film can be homogeneously deposited having improved smoothness; i.e., the film 15 is vapor-deposited being highly and closely adhered to the under-layer surface X effectively solving the problem of peeling.

According to the present invention, the advantage of foaming can be utilized to a maximum degree and, at the same time, the film can be vapor-deposited in a highly and closely adhered manner despite of foaming, effectively preventing the peeling and effectively exhibiting the advantages of the vapor-deposited film.

If the invention is applied to, for example, packing containers such as bottles, characteristics due to foaming, such as small weight and light-blocking property can be effectively exhibited. Besides, the vapor-deposited film works to effectively alleviate a decrease in the gas-barrier property caused by foaming and, further, works to improve the gas-barrier property.

### EXAMPLES

Described below are Examples and Comparative Examples, and their results are shown in Table 1. As for the amounts of oxygen permeating through the bottles in Table 1, the gas-barrier property was judged to be favorable if the amount of oxygen permeating through the bottle of after the vapor deposition was smaller than one-half the representative amount, i.e., 0.06 cc/bottle/day of oxygen permeating through the bottle of before the vapor deposition, i.e., if the amount of oxygen permeating through the bottle of after the vapor deposition was smaller than 0.03 cc/bottle/day.

### (Example 1)

A PET resin for bottle containing 0.15% of a nitrogen gas and having an intrinsic viscosity (IV) of 0.84 dL/g was injected into a mold cavity maintaining a pressure therein of 5 MPa by blowing high-pressure air and a temperature of 30°C and, thereafter, the pressure therein was maintained at 50 MPa for 18 seconds. After another 12 seconds have passed, the mold was opened. There was obtained a preform for container of the shape of a test tube in a substantially unfoamed state in which the gas has been dissolved and having a smooth surface and an overall length of about 110 mm.

The preform was, further, heated and foamed, and was directly blow-formed to obtain a foamed blow-formed bottle having a thickness in the body portion of about 600 *µ*m and a capacity of about 500 ml. The heating was conducted from both the outer surface side and the inner surface side, and the heating condition was so adjusted that the temperature was 99°C on the inner surface side of the preform (at a portion 45 mm away from the nozzle top panel).

After the blow-formed bottle was set in the chamber, the interior and exterior of the bottle were evacuated. An HMDSO (hexamethyldisiloxane) was introduced as the reaction gas and after a predetermined pressure was reached, microwaves of 2.45 GHz were introduced to form an SiOx film. From the following SEM photograph, the thickness of the film at this moment was found to be about 20 nm.

The obtained bottle having the film vapor-deposited on the inner surface thereof was measured for its amount of oxygen permeation by using an oxygen barrier testing machine (OX-TRAN manufactured by MOCON Co.) (37°C) to find that the amount of oxygen that has permeated through was 0.003 cc/bottle/day, which was a favorable result (before the vapor deposition, it was 0.06 cc/bottle/day).

By using the scanning electron microscope (SEM), the cross section of the bottle body portion was photographed and by using an image analysis software (Mac-View manufactured by Mountec Co.) plated in the market, the area ratio of the foamed cells was found in cross section of the inner surface layer portion of the bottle body portion (range from the surface of the foamed plastic formed body serving as the under-layer for vapor-depositing the film down to a depth of 50 *µ*m). The average porosity was calculated to be 8% on the average at three points. For comparison, further, the area ratio of the foamed cells was found in cross section of the outer surface layer portion of the bottle body portion (range from the surface of the foamed plastic formed body on the side that is not serving as the under-layer for vapor-depositing the film down to a depth of 50 *µ*m), and from which the average porosity was calculated to be 12% on the average at three points.

### (Example 2)

A preform was formed, a bottle was formed, and a film was vapor-deposited thereon in the same manner as in Example 1 but so adjusting the heating conditions that the temperature was 102°C on the inner surface side of the preform of when it was being heated.

The amount of oxygen that has permeated through the obtained bottle having its inner surface vapor-deposited was as good as 0.004 cc/bottle/day (before the vapor deposition, the amount was 0.06 cc/bottle/day).

The average porosity was 19% in the inner surface layer portion of the bottle body portion, and was 24% in the outer surface layer portion thereof.

### (Example 3)

A preform was formed, a bottle was formed, and a film was vapor-deposited thereon in the same manner as in Example 1 but so adjusting the heating conditions that the temperature was 104°C on the inner surface side of the preform of when it was being heated.

The amount of oxygen that has permeated through the obtained bottle having its inner surface vapor-deposited was as good as 0.007 cc/bottle/day (before the vapor deposition, the amount was 0.07 cc/bottle/day).

The average porosity was 25% in the inner surface layer portion of the bottle body portion, and was 32% in the outer surface layer portion thereof.

### (Example 4)

First, a preform was formed in the same manner as in Example 1. A bottle was formed and a film was vapor-deposited in the same manner as in Example 1 but at the time of heating the preform prior to blowing, adjusting the heating conditions in a manner that the heating was strong from the outer surface side but was weak from the inner surface side so as to positively foam the regions other than the vapor deposition surface (inner surface). The temperature was 110°C on the outer surface of the preform and was 94°C on the inner surface thereof of when it was being formed into the bottle.

The amount of oxygen that has permeated through the obtained bottle having its inner surface vapor-deposited was as good as 0.013 cc/bottle/day (before the vapor deposition, the amount was 0.08 cc/bottle/day).

The average porosity was 11% in the inner surface layer portion of the bottle body portion, and was 39% in the outer surface layer portion thereof.

### (Example 5)

First, a preform was formed in the same manner as in Example 1. The preform that was formed was stored for about one week to let the gas dissolved near the surface layer portion to be released to the atmosphere. Thereafter, a bottle was formed and a film was vapor-deposited in the same manner as in Example 1 but so adjusting the heating conditions that the temperature was 108°C on the inner surface side of the preform of when it was being heated.

The amount of oxygen that has permeated through the obtained bottle having its inner surface vapor-deposited was as good as 0.01 cc/bottle/day (before the vapor deposition, the amount was 0.09 cc/bottle/day).

No bubble was observed in the inner surface layer portion of the bottle body portion (average porosity was 0%).

### (Example 6)

First, a preform was formed and a bottle was formed therefrom in the same manner as in Example 1. After the bottle was set in the chamber, a diamond-like carbon (DLC) film was deposited under the same film-forming conditions as those of Example 1 but changing the reactive gas species into acetylene. From a SEM photograph, the thickness of the DLC film was about 20 nm.

The amount of oxygen that has permeated through the obtained bottle having its inner surface vapor-deposited was as good as 0.003 cc/bottle/day (before the vapor deposition, the amount was 0.06 cc/bottle/day).

The average porosity was 8% in the inner surface layer portion of the bottle body portion, and was 12% in the outer surface layer portion thereof.

### (Comparative Example 1)

A preform was formed, a bottle was formed, and a film was vapor-deposited thereon in the same manner as in Example 1 but so adjusting the heating conditions that the temperature was 109°C on the inner surface side of the preform of when it was being heated.

The amount of oxygen that has permeated through the obtained bottle having its inner surface vapor-deposited was 0.05 cc/bottle/day, and good barrier property was not obtained (before the vapor deposition, the amount was 0.08 cc/bottle/day).

The average porosity was 32% in the inner surface layer portion of the bottle body portion, and was 41% in the outer surface layer portion thereof.

### (Comparative Example 2)

A preform was formed, a bottle was formed, and a film was vapor-deposited thereon in the same manner as in Example 1 but so adjusting the heating conditions that the temperature was 112°C on the inner surface side of the preform of when it was being heated.

The amount of oxygen that has permeated through the obtained bottle having its inner surface vapor-deposited was 0.07 cc/bottle/day, and a good barrier property was not obtained (before the vapor deposition, the amount was 0.09 cc/bottle/day).

The average porosity was 37% in the inner surface layer portion of the bottle body portion, and was 47% in the outer surface layer portion thereof.

### (Comparative Example 3)

A preform was formed, a bottle was formed, and a film was vapor-deposited thereon in the same manner as in Example 1 but so adjusting the heating conditions that the temperature was 118°C on the inner surface side of the preform while weakening the heating from the outer surface side of the preform to suppress the foaming on the outer surface side thereof.

The amount of oxygen that has permeated through the obtained bottle having its inner surface vapor-deposited was 0.08 cc/bottle/day, and a good barrier property was not obtained (before the vapor deposition, the amount was 0.09 cc/bottle/day).

The average porosity was 38% in the inner surface layer portion of the bottle body portion, and was 18% in the outer surface layer portion thereof.

In Comparative Examples 1, 2 and 3, favorable gas-barrier property was not obtained presumably because of the following reasons. If the porosity is high near the vapor deposition surface (surface of the foamed plastic formed body serving as the under-layer on where the film is to be vapor-deposited), the resin density becomes relatively low in the resin portions around the bubbles and the resin becomes locally thin. Besides, the vapor deposition often becomes rugged to a large extent being affected by the growth of bubbles. If the thickness locally decreases or if there exists a rugged skin layer, the thickness of the vapor-deposited film becomes non-uniform on the vapor deposition surface, and the vapor-deposited film is often locally peeled off due to local thermal deformation or the external force during the vapor deposition. The irregular thickness or the local peeling of the vapor-deposited film presumably accounts for the exhibition of poor gas-barrier property. It is considered that there are values such as threshold values for maintaining the uniformity of adhesion of the vapor-deposited film or for maintaining the film strength. If the film is weakly adhered or peeled off even locally, then the gas-barrier property decreases over the bottle as a whole; i.e., the gas-barrier property sharply decreases with the porosity of about 30% as a boundary.

**Table 1**

| | Inner surface temp. of when PF is heated (°C) | Kind of vapor-deposited film | Porosity in bottle surface layer (%) | | Amount of oxygen permeating through bottle (cc/bottle/ day) | | |
|---|---|---|---|---|---|---|---|
| | | | Outer surface layer (non-deposition surface) | Inner surface layer (deposition surface) | Before deposited | After deposited | Evaluation |
| Ex. 1 | 99 | SiOx | 12 | 8 | 0.06 | 0.003 | good |
| Ex. 2 | 102 | SiOx | 24 | 19 | 0.06 | 0.004 | good |
| Ex. 3 | 104 | SiOx | 32 | 25 | 0.07 | 0.007 | good |
| Ex. 4 | 94 | SiOx | 39 | 11 | 0.08 | 0.013 | good |
| Ex. 5 | 108 | SiOx | 0 | 0 | 0.09 | 0.01 | good |
| Ex. 6 | 99 | DLC | 12 | 8 | 0.06 | 0.003 | good |
| Comp. Ex. 1 | 109 | SiOx | 41 | 32 | 0.08 | 0.05 | poor |
| Comp. Ex. 2 | 112 | SiOx | 47 | 37 | 0.09 | 0.07 | poor |
| Comp. Ex. 3 | 118 | SiOx | 18 | 38 | 0.09 | 0.08 | poor |

### Description of Reference Numerals:

- 1:: foamed cells
- 10:: foamed plastic formed body
- 10a:: surface layer portion
- 15:: vapor-deposited film

## Claims

1. A vapor-deposited foamed body having a film vapor-deposited on the surface of a foamed plastic formed body containing foamed cells therein, wherein in the surface of the foamed plastic formed body serving as the under-layer on where the film is to be vapor-deposited, the porosity of the foamed cells is suppressed to be not more than 30% in the surface layer portion to a depth of 50 *µ*m from said surface.

2. The vapor-deposited foamed body according to claim 1, wherein said vapor-deposited film is a metal oxide film or a hydrocarbon film formed by the plasma CVD method.

3. The vapor-deposited foamed body according to claim 1, wherein said foamed plastic formed body has been stretch-formed.

4. The vapor-deposited foamed body according to claim 1, wherein said foamed plastic formed body is a container.

5. The vapor-deposited foamed body according to claim 1, wherein said foamed plastic formed body is a container, and said film has been vapor-deposited on the inner surface thereof that comes in contact with the content.

6. The vapor-deposited foamed body according to claim 1, wherein said vapor-deposited film has a thickness in a range of 10 to 50 nm.

## Patentansprüche

1. Aufgedampfter Schaumkörper mit einer Schicht, die auf der Oberfläche eines mit Schaumstoff ausgebildeten Körpers aufgedampft ist, die Schaumzellen enthält, wobei in der Oberfläche des mit Schaumstoff ausgebildeten Körpers, der als der Untergrund dient, auf dem die Schicht aufdampfbar ist, die Porosität der Schaumzellen unterdrückt ist, um nicht mehr als 30% in dem Oberflächenschichtabschnitt bis zu einer Tiefe von 50 µm von der Oberfläche zu sein.

2. Aufgedampfter Schaumkörper nach Anspruch 1, wobei die aufgedampfte Schicht eine Metalloxidschicht oder eine Kohlenwasserstoffschicht ist, die durch das Plasma-CVD-Verfahren ausgebildet ist.

3. Aufgedampfter Schaumkörper nach Anspruch 1, wobei der mit Schaumstoff ausgebildete Körper streckgezogen ist.

4. Aufgedampfter Schaumkörper nach Anspruch 1, wobei der mit Schaumstoff ausgebildete Körper ein Behälter ist.

5. Aufgedampfter Schaumkörper nach Anspruch 1, wobei der mit Schaumstoff ausgebildete Körper ein Behälter ist, und wobei die Schicht auf seiner Innenfläche aufgedampft ist, die den Inhalt berührt.

6. Aufgedampfter Schaumkörper nach Anspruch 1, wobei die aufgedampfte Schicht eine Dicke in einer Größenordnung von 10 bis 50 nm hat.

## Revendications

1. Corps expansé à dépôt en phase vapeur présentant un film déposé en phase vapeur sur la surface d'un corps façonné en matière plastique expansé contenant des alvéoles expansées dans celui-ci, dans lequel dans la surface du corps façonné en matière plastique expansé servant de sous-couche sur laquelle le film doit être déposé en phase vapeur, la porosité des alvéoles expansées est supprimée pour ne pas être supérieure à 30 % dans la portion de couche de surface jusqu'à une profondeur de 50 µm à partir de ladite surface.

2. Corps expansé à dépôt en phase vapeur selon la revendication 1, dans lequel ledit film déposé en phase vapeur est un film d'oxyde métallique ou un film hydrocarboné formé par le procédé CVD au plasma.

3. Corps expansé à dépôt en phase vapeur selon la revendication 1, dans lequel ledit corps façonné en matière plastique expansé a été façonné par étirage.

4. Corps expansé à dépôt en phase vapeur selon la revendication 1, dans lequel ledit corps façonné en matière plastique expansé est un récipient.

5. Corps expansé à dépôt en phase vapeur selon la revendication 1, dans lequel ledit corps façonné en matière plastique expansé est un récipient, et ledit film a été déposé en phase vapeur sur la surface interne de celui-ci qui est en contact avec le contenu.

6. Corps expansé à dépôt en phase vapeur selon la revendication 1, dans lequel ledit film déposé en phase vapeur présente une épaisseur dans un intervalle de 10 à 50 nm.
